(19)

Europäisches
Patentamt
European
Patent Office
Office européen
des brevets

(11)  **EP 2 696 499 A1**

(12)  **EUROPEAN PATENT APPLICATION**

(43) Date of publication:
**12.02.2014 Bulletin 2014/07**

(21) Application number: **12290270.3**

(22) Date of filing: **10.08.2012**

(51) Int Cl.:
*H03F 1/02* (2006.01)       *H03F 1/42* (2006.01)
*H03F 1/56* (2006.01)       *H03F 3/60* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Alcatel Lucent
75007 Paris (FR)**

(72) Inventor: **Wong, James N.
Richmond, Surrey TW9 3JX (GB)**

(74) Representative: **Lupton, Frederick
51 Bullens Green Lane
Colney Heath
St. Albans, Herts. AL4 0QR (GB)**

(54)  **Power amplifier for mobile telecommunications**

(57)     A Doherty amplifier including a carrier amplifier (Main), and at least one peaking amplifier (Peak), wherein an impedance inverter (6) at the output of the carrier amplifier includes first and second parallel paths, the first path (10) including a first λ/4 line impedance (L2a) providing an impedance inversion, and the second path (12) including a variable second impedance, including transmission line lengths (L2b, L3) and voltage controlled varactor devices (C1, C2) for adjustment of frequency response and/or output impedance of the impedance inversion means, in order to provide optimal impedance over a broadband range of frequencies.

Figure 3.

EP 2 696 499 A1

**Description**

Field of the Invention

The present invention relates to a power amplifier employed in mobile telecommunications systems, particularly an RF power amplifier commonly known as a Doherty amplifier.

Background Art

US Patent No. 2,210,028 to Doherty describes the principle of operation of the Doherty amplifier. A Doherty amplifier includes a main or carrier amplifier, usually biased into class B or AB, with a peaking amplifier coupled in parallel and biased into class C, so as to switch on at modulation peaks. This provides a more efficient use of amplifier capability, since the carrier amplifier may be set to provide maximum power efficiency at saturation, backed off by -6 dB from the peak output. When the peaking amplifier switches in at the -6 dB point to increase power to the antenna load, an impedance inverter at the output of the carrier amplifier senses an increase in load impedance and provides an apparent lower impedance at the carrier amplifier output, thereby increasing power output of the carrier amplifier. Impedance inverters are usually implemented by quarter wavelength ($\lambda$/4) transmission line lengths.
There has been a great deal of development in improving the operation and efficiency of the Doherty Amplifier, particularly in the field of mobile telecommunications, and particularly improving the efficiency of the Doherty amplifier at reduced power outputs. "Efficiency" is generally regarded as the ratio of RF transmission output power to DC input power. Existing designs of Doherty Amplifiers that addresses efficiency enhancements at reduced power outputs are listed as follow:

    i. Symmetric Doherty Amplifiers (Symmetric meaning equal values of input power are applied to carrier and peaking amplifiers) with variable drain voltage power supply;
    ii. Asymmetric Doherty Amplifiers (Asymmetric meaning unequal values of input power are applied to carrier and peaking amplifiers) with fixed drain voltage power supply;
    iii. N-way Doherty Amplifiers with fixed or variable drain voltage power supply (where N is an integer $\geq$ 3);
    iv. Envelope tracking techniques together with variable drain voltage power supply.

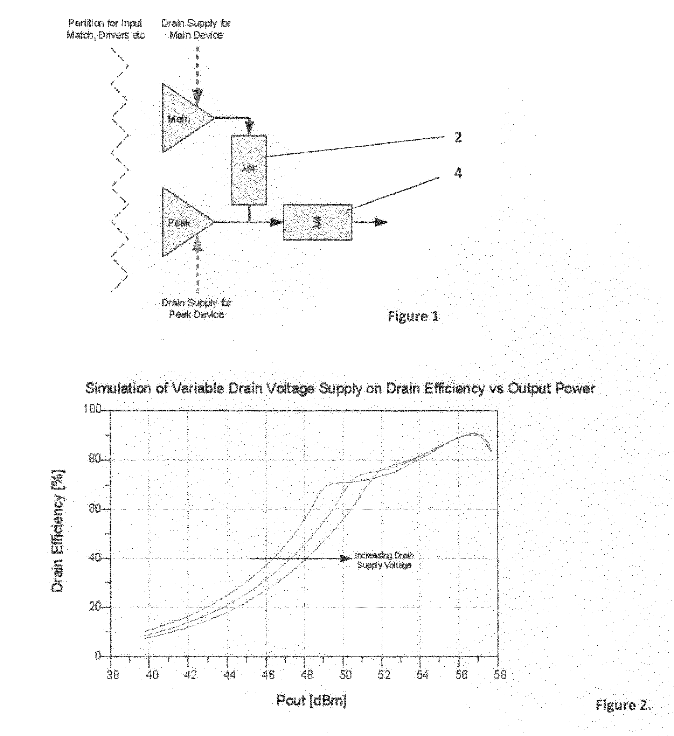

Figures 1 show and 2 illustrate a prior art implementation, wherein as shown in the block diagram of Figure 1, a Doherty amplifier comprises a main amplifier Main and peak amplifier Peak, wherein the output of Main is coupled to the output of Peak by an impedance inverting $\lambda$/4 transmission line 2, and the output of Peak is coupled to the output of the amplifier by a further $\lambda$/4 transmission line 4. An appropriate input configuration is provided comprising input matches, drivers, power division, etc. Independent drain voltage supplies are provided for Main and Peak.
The fundamental principle behind such approach is to capitalize on differences in transmit powers between the Main and Peak devices according to the following expression:

$$\text{Pout}_{(RF)} = V^2_{(drain\ voltage)} / (2 \times R_{opt}) - \text{Equation (1)}$$

where:

    $\text{Pout}_{(RF)}$ = RF Power Output;
    $V_{(drain\ voltage)}$ = Drain Supply Voltage applied to transistor device forming the amplifier;
    $R_{opt}$ = Resistive load impedance for maximum output RF power transfer

Figure 2 shows the effects of varying the drain supply voltage of the main device. In this instance, the supply voltage to the peak amplifer is kept at 28V, while the supply voltage to the main amplifier is varied between 20V, 24V & 28V, and it may be seen that efficiency may be maintained for varying output power, by adjusting drain supply voltage, or alternatively for a given output power, efficiency may be increased by reducing drain voltage.. Therefore the use of variable, independent voltage power supplies may be attractive as a quick solution of implementation. However, the cost and complexity of such approach remains unattractive, and since a variable voltage supply together with digital control is required, the overall system efficiency improvement may be close to nothing or marginal.
For an asymmetrical device approach as in ii. above, the transfer characteristic imbalances between the devices have to be addressed (especially phase imbalance). These can be addressed via envelope tracking techniques as in iv., but this requires additional complexity and additional power consumption which may negate the overall system benefits. Designs according to iii. above naturally require additional complexity.

Summary of the Invention

Embodiments of the invention provide, within a Doherty amplifier configuration, an impedance inverter device appearing as a λ/4 line, but which allows adjustments to be made in a way such that the characteristic impedance of this line changes optimally. In addition to overcoming the frequency limitation of a standard λ/4 line, this approach also allows line adjustments to be made and optimized according to the frequency of operation being used. Thus embodiments provide an impedance inverter device in the output path of the main amplifier, wherein the impedance of the inverter device may provide an optimally broad frequency response over a frequency range of interest. The impedance is adjustable, so that the frequency characteristics may be adjusted and/or impedance adjustments may be made to improve the efficiency of the Doherty amplifier at a specific frequency over a broad range of frequencies.

Such impedance inverter device is based, in embodiments, on a configuration of transmission line lengths and adjustable impedances such that the device appears within the circuit as a λ/4 transmission line length with adjustable characteristic impedance $Z_0$. This permits implementation of the device on for example circuit tracks of a printed circuit board, and permits adjustments to be made within the framework of impedance calculations of λ/4 lines. In addition to overcoming the frequency bandwidth limitation of a standard λ/4 line, embodiments also allow line adjustments to be made and optimized according to the frequency of operation being used. This is in contrast to a λ/4 line configured as a single length, which is operable as an impedance inverter only at a single frequency, and within a narrow band of frequencies. The device may comprise first and second parallel paths (a third path may be added if desired), the first path including a first impedance providing an impedance inversion at a first frequency, and the second path including an adjustable impedance, whereby to provide an overall broadband response with adjustable characteristics..

Whilst said first and second impedances may be formed of discrete components, it is preferred to form them as transmission line lengths. As preferred said second impedance includes, coupled to one or more transmission line lengths, one or more voltage controlled capacitors (varactors), wherein the voltage applied may be preset or dynamically variable, as described below.

As preferred a further wideband impedance inverter device is coupled between the output of the impedance inverter device of this invention, and the amplifier output. This may be a multi-sectioned or tapering transmission line length, e.g. triangular, exponential, or as preferred Klopfenstein Taper. Alternatively, a further impedance device of this invention may be employed.

The present Doherty amplifier may additionally include variable drain voltage supplies, asymmetric input power splitting, more than one peaking amplifier, and/or an envelope tracking arrangement.

The present invention therefore provides a power amplifier including a main amplifier, and at least one peaking amplifier, the output of said main amplifier being coupled through an impedance inversion means to a power amplifier output, and the output of said one peaking amplifier being coupled to said main amplifier output, and wherein said one peaking amplifier is configured to switch on with increase in input power,
wherein said impedance inversion means includes first and second parallel paths, the first path including a first impedance providing an impedance inversion, and the second path including a variable second impedance means, whereby to provide an overall broadband frequency response.

Brief Description of the Drawings

A preferred embodiment of the invention will now be described, by way of example only, with reference to the accompanying drawings, wherein:

Figure 1 is a circuit diagram of a known Doherty amplifier implementation incorporating variable power supplies;
Figure 2 is a graph illustrating the variation of efficiency with variation of drain supply voltage on the main or carrier amplifier of Figure 1;
Figure 3 is a schematic view of a Doherty amplifier according to an embodiment of the invention, incorporating a broadband impedance transformer circuit;
Figure 4 is a lumped circuit equivalent representation of the transformer circuit of Figure 3;
Figure 5 is an illustration of an implementation of part of the circuit of Figure 3, operating at 2GHz;
Figure 6 is a graph illustrating variation in drain efficiency for the circuit of Figure 3; and
Figure 7 is a graph showing variation of S parameters with frequency for the circuit of Figure 3, and for a λ/4 line, for different VSWR ratios.

Description of the Embodiment

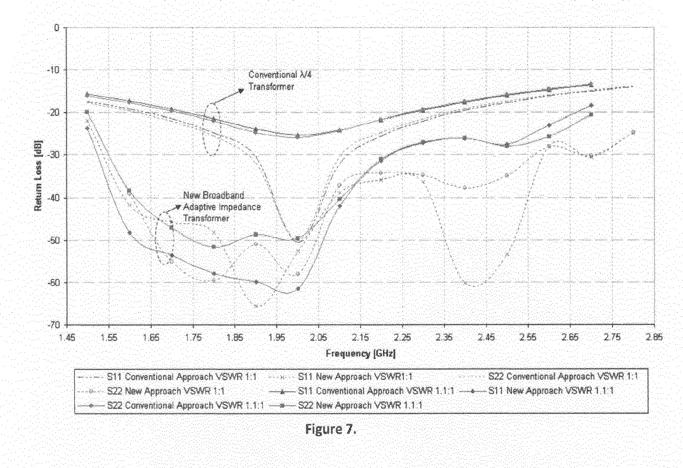

Taking an example of Band 2 in the US (1930-1995MHz), certain network operators have segregated licensed frequency bands across the country (i.e. 1930-1945MHz, 1975-1995MHz). It would make good sense to have a single radio equipment capable of covering the entire 65MHz band. It is possible to design power amplifiers to cover the full 65MHz bandwidth. However, these network operators also have licensed frequency bands in Band 4 (2110-2155MHz). In order to have a single radio equipment covering Band 2 & 4 simultaneously, this requires either 2 separate amplifier designs or even better, a single amplifier design covering both bands. In conventional Doherty designs, bandwidth is often an issue and is nominally limited by the $\lambda/4$ line transformers. Figure 7 shows S11 and S22 for VSWRs of 1:1 and 1:1.1. It is clear that for a $\lambda/4$ line transformer, from the return loss for a VSWR of 1:1.1, that the transformer network has degraded. Hence from equation (1) above, where the value of Ropt is changed to a value which has a VSWR of 1:1.1, then the value of output power Pout will be less then the ideal Pout. This has an impact of efficiency performance of the amplifier. It is further clear that a $\lambda/4$ line transformer provides a reduced return loss only within a narrow band about a single frequency (as shown 2 GHz).

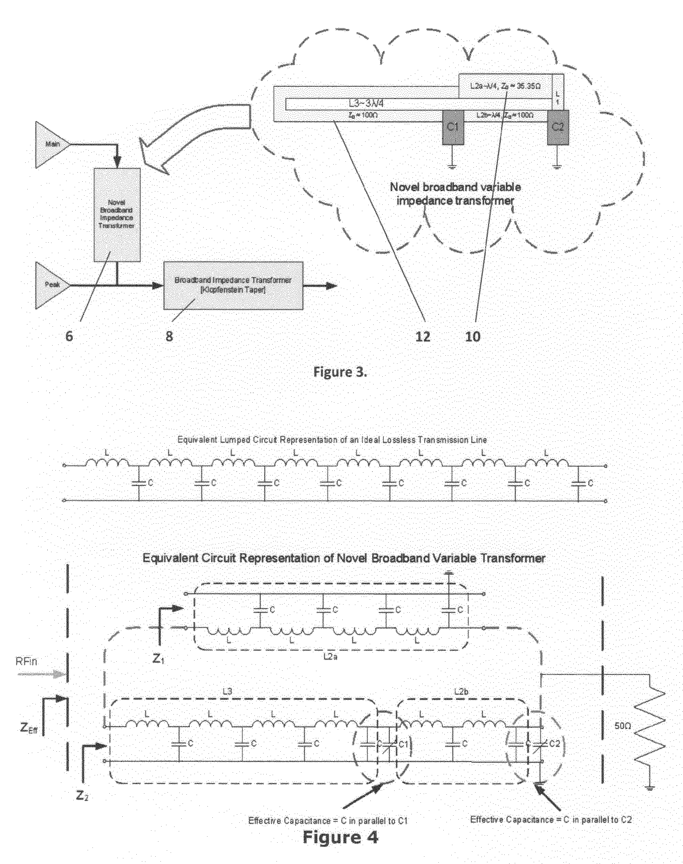

Figure 3 shows a schematic circuit diagram of the structure of an embodiment of this invention. A Doherty amplifier configuration has a main amplifier (Main) and a peaking amplifier (Peak). The output of Main is coupled to the output of Peak via the broadband impedance transformer 6 of this embodiment, which is shown in schematic microstrip form in the inset. The outputs of Main and Peak are coupled to an output load (not shown) by a $\lambda/4$ line transformer 8 formed as a Klopfenstein taper broadband impedance transformer.

As shown in the inset of Figure 3 and in the lumped circuit equivalent representation of Figure 4, , the RF input from Main is applied to the transformer which has an input impedance $Z_{Eff}$ and which is formed of two parallel paths, the first path 10 having an impedance $Z_1$ and comprising a $\lambda/4$ line L2a, and the second path 12 having an impedance $Z_2$ and comprising a $3\lambda/4$ line L3 in series with a $\lambda/4$ line, varactors diodes C1 and C2 being coupled to the respective ends of L3 and L2b. The two parallel paths are coupled to an output load via a line L1. C1 and C2 are voltage controlled varactor diodes. Line L1 has a high characteristic impedance, but of a very short length, much less than $\lambda/4$, linking between lines L2a and L2b (which are each approximately $\lambda/4$ in length at the center frequency of operation). C1 and C2 are located between the ends of Line 2b. Lines L2b and L3 are of equal characteristic impedance 100 $\Omega$, which is about three times higher than the characteristic impedance of Line L2a, 35.35$\Omega$. Line L3 is approximately $3\lambda/4$ in length. An output load of 50$\Omega$ is coupled to line L1.

Referring to Figure 4, the broadband transformer circuit presents an impedance $Z_{eff}$ at its input, composed of two parallel impedances $Z_1$ (10; L2a) and $Z_2$ (12; L3 + L2b), and the output is coupled to a 50$\Omega$ load. The input impedance $Z_{Eff}$ of the broadband transformer may be appreciated as follows: Firstly, assume a single centre frequency $F_0$, $Z_1$ and $Z_2$ are isolated:

● Then $L_{2a}$ has a characteristic impedance of $Z_{2a}$, which is SQRT($Z_1$x100);
● At $F_0$, $L_3$ is $3\lambda/4$ and $L_{2b}$ is $\lambda/4$, making it up to be A at $F_0$. Hence, an open circuit at the right end of $L_{2b}$ will appear as an open circuit at the left end of $L_3$. Making $Z_2 = \infty$ (infinite).

Secondly, assume @ $F_0$, but $Z_1$ and $Z_2$ are not isolated (i.e. $Z_1$ will be loaded by $Z_2$ by some amount):

● Let $Z_2'$ be located at the intermediate point between $L_3$ and $L_{2b}$. Then $Z_2' = [(Z_{2b})^2] /100$.
● Then $Z_2 = [(Z_{L3})^2]/Z_2' = \{[(Z_{L3})^2]/ [(Z_{2b})^2]\}$x100 : the dependency of $Z_2$ on $L_3$ and $L_{2b}$ can be seen here.
● Unfortunately, due to the higher characteristic impedance of path $Z_2$, current flowing between $Z_1$ is always higher. The high impedance line $L_1$ acts like a high impedance load, hence contributing to this current ratio difference but more importantly, aids in minimizing insertion loss of this network.
● The effective Z as seen by the RF signal, is then the parallel of $Z_1$ and $Z_2$.

o Hence, if $Z_1 = R_1 +jX_1$ and $Z_2 = R_2 + jX_2$, then
o Re(Z) = $Z_1Z_2/(Z_1+Z_2)$;

Since the major part of current flow occurs through L2a, the transformer may be regarded roughly as a $\lambda/4$ line resonant (L2a) at a first frequency having in parallel a path, also resonant, for providing a broadband response and for adjusting characteristics. In the case of a fixed $\lambda/4$ length of transmission line, it will exhibit a single perfect 1:1 VSWR @ $F_0$ [i.e. 25$\Omega$ at input and 50$\Omega$ at output]. Going higher or lower than $F_0$, this VSWR changes [i.e. 25$\pm$R $\pm$jX$\Omega$]. R is the real part of resistance and X is the reactance [capacitive or inductive]. X becomes larger as the frequency deviates away from $F_0$. The role of $Z_2$, allows the reactances to be minimised. This may be seen in that firstly the series connection of a $3\lambda/4$ and a $\lambda/4$ line, with varactors diodes C1 and C2 coupled thereto will broaden out the frequency response and permit the reactance components to be optimised at frequencies higher or lower than $F_0$. The variable capacitance

varactors diodes C1 and C2 permit tuning of the transformer in any particular circumstance. Thus the voltages applied to C1 and C2 may be varied according to a variety of circumstances. Thus for example the voltages may be preset to cover a frequency band or bands being used over a period of time. There also exists a value of C1 & C2 that allows both US Band 2 and Band 4, in the example given above, to operate simultaneously. Alternatively, the voltages may be dynamically variable, in accordance with the traffic mean frequency at any instant, so as to optimise impedance of the transformer for that mean frequency.

As stated above, the outputs of Main and Peak are coupled to an output load (not shown) by a $\lambda/4$ line transformer 12 formed as a Klopfenstein taper broadband impedance transformer. The Klopfenstein taper addresses wideband frequencies - but it only allows a fixed impedance transformation to occur. As an example, a $25\Omega$ to $50\Omega$ taper will exhibit broadband VSWR characteristics between the 2 ports as long as the incident port ($25\Omega$ port) remains purely resistive. Unfortunately, the nature of active devices as in the case of transistors used for signal amplification, by replacing Ropt with Zopt in equation (1), Zopt is now frequency dependent and contains a reactance, $Zopt = Ropt + jXopt$. The transformer of this embodiment allows a reactance to be added to the real part; hence the active device will always be presented with the optimum impedance of Zopt, and transforming this impedance to a real part impedance as required by a Klopfenstein taper. As illustrated in Figure 3, this embodiment allows either reactive or real impedances to be transformed into a real impedance in order to allow the Klopfenstein taper 12 to further transform into $50\Omega$. In an alternative embodiment, it is possible to have two versions of this embodiment back-to-back.

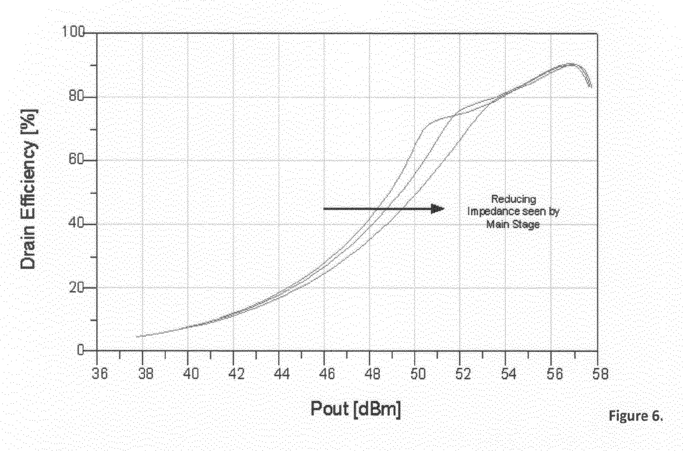

Figure 6 show the effects of varying the impedance of this circuit (by applying varying voltages to C1 and C2) at a fixed frequency on drain efficiency vs. output power, and the similarity with the characteristics of Figure 2 may be noted, indicating the broadband transformer is an alternative to adjustment of drain voltage.

Figure 7 shows a comparison of the frequency response between a standard $\lambda/4$ microstrip transformer with the broadband impedance transformer of this embodiment. It may be seen from Figure 7 that whilst Ropt (Equation 1) is frequency dependent, this broadband transformer is able to address this limitation by re-adjusting its VSWR (by appropriate variation of voltages applied to C1 and C2) such that the Doherty amplifier is presented with its optimum load impedance.

It may be seen in Figure 7 that for a perfect VSWR of 1:1, for the broadband transformer of this embodiment, and with appropriate adjustments of voltages applied to C1 and C2, there is a first minimal area for S11 around 1.90 GHz, followed by a second minimum around 2.4 GHz,. Further the overall minimal area between 1.6 and 2.6 GHz, encompassing these two minima provides a much reduced return loss as compared with a $\lambda/4$ line, and provides a broadband response.

It may be seen particularly from Figure 6, that the broadband transformer is an alternative to variable power supply for improved efficiency performance at reduced power levels. It can operate with a fixed voltage supply. It only relies on changes to the varactor diodes C1, C2. Figure 6 shows the efficiency performance by varying the VSWR of the transformer, where for example for an output of 50dBm, Drain Efficiency can be varied from less than 50% to over 60%. This has a similar profile/characteristic of the more cumbersome variable voltage power supply approach, as shown in Figure 2.

The advantages of the broadband transformer of this embodiment are summarised in the following table:

|  | Prior Art Approach | Embodiment Approach |
|---|---|---|
| Impedance Transformation [e.g. $25\Omega$ to $50\Omega$] | Single Frequency Point only | Much wider frequencies. |
| Variable Impedance Transformation at single frequency [e.g. $25\pm2.5\Omega$ to $50\Omega$] | Not applicable | Applicable |

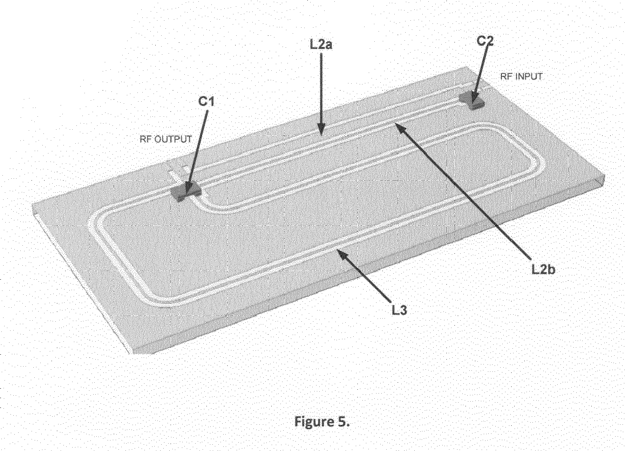

Figure 5 illustrates an example of the practical design and implementation of the broadband transformer, wherein the transmission line lengths L2a, L2b, L3 are formed as microstrip on a circuit board.

Therefore advantages of the invention, at least in embodiments, are:

● a cost effective technique for enabling consistent and optimum efficiency performance of a Doherty Amplifier across a wide range of frequencies across a wide output power dynamic range;
● An enabler for re-use of amplifier circuits, both in base stations and handsets, which would otherwise have been narrow-band and hence allowing common assets to address market requirements much faster. Ability to adjust VSWR while in operation further improves the reliability of the active transistor devices;
● A technique which can be employed alone or in conjunction with prior art techniques i. - iv. as itemised above;
● The use of varactor diodes permits adjustment of broadband frequency response and impedance to a variety of situations. Prior multiple product designs address the multiple frequency bands of the operators. Embodiments of the invention provide a single common product design that addresses multiple requirements, the sheer volumes and ease of common asset use helps in overall cost reduction in production and faster time-to-market.

● Mobile data traffic is never 100% 24hrs every day. It is variable. One possible approach is to use variable power supply to track dynamic traffic. Unfortunately, these power supplies must have extremely fast switching response times with minimal settling time. If tracked improperly, it may affect output power as well as spectral emissions. Embodiments of the present broadband transformer provide an alternative to variable power supply for improved efficiency performance at reduced power levels. They can operate with a fixed voltage supply.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1. A power amplifier including a main amplifier, and at least one peaking amplifier, the output of said main amplifier being coupled through an impedance inversion means to a power amplifier output, and the output of said one peaking amplifier being coupled to said main amplifier output, and wherein said one peaking amplifier is configured to switch on with increase in input power,
wherein said impedance inversion means includes first and second parallel paths, the first path including a first impedance providing an impedance inversion, and the second path including a variable second impedance means, whereby to provide an overall broadband frequency response.

2. A power amplifier according to claim 1, said second impedance including variable reactive means for adjustment of frequency response and/or impedance of said impedance inversion means.

3. A power amplifier according to claim 1 or 2, said first impedance comprising a first transmission line length having a first characteristic impedance, and said second impedance includes second transmission line length means having a second characteristic impedance.

4. A power amplifier according to claim 3, wherein said first transmission line length means is one quarter of a wavelength long at a resonant frequency, or an odd multiple thereof, and the second transmission line length means is one wavelength long at a resonant frequency, or a multiple of one half wavelengths thereof.

5. A power amplifier according to claim 4, wherein said second transmission line length means comprise a second transmission line length, preferably three quarters of a wavelength long, and a third transmission line length, preferably one quarter of a wavelength long.

6. A power amplifier according to claim 5, wherein each of said second and third transmission lines lengths have a characteristic impedance that is substantially higher than that of the first transmission line length.

7. A power amplifier according to claim 5 or 6, said second impedance including variable reactance means comprising a first variable reactance coupled to said second transmission line length, and a second variable reactance coupled to said third transmission line length.

8. A power amplifier according to claim 2 or 7, wherein variable reactance means comprises one or more voltage controlled varactor diodes.

9. A power amplifier according to claim 8, arranged such that either a fixed voltage or a dynamically variable voltage is applied to said varactor diodes, variable in dependence on a frequency of operation.

10. A power amplifier according to any preceding claim, including a further impedance inversion means coupled between the outputs of the main and peaking amplifiers and the power amplifier output, which has a broadband frequency response.

11. A power amplifier according to claim 10, wherein the further impedance inversion means comprises a multi-sectioned or tapered transmission line length.

12. A power amplifier according to claim 11, wherein the further impedance inversion means comprises a Klopfenstein Taper.

Figure 1

Simulation of Variable Drain Voltage Supply on Drain Efficiency vs Output Power

Figure 2.

L2a~λ/4, $Z_0 \approx 35.35\Omega$

L3~3λ/4

$Z_0 \approx 100\Omega$

L2b~λ/4, $Z_0 \approx 100\Omega$

C1

C2

L1

Main

Peak

Novel Broadband Impedance Transformer

Broadband Impedance Transformer [Klopfenstein Taper]

Novel broadband variable impedance transformer

6        8                                    12    10

Figure 3.

Equivalent Lumped Circuit Representation of an Ideal Lossless Transmission Line

Equivalent Circuit Representation of Novel Broadband Variable Transformer

RFin

$Z_1$

$Z_{Eff}$

$Z_2$

L2a

L3

L2b

C1

C2

50Ω

Effective Capacitance = C in parallel to C1

Effective Capacitance = C in parallel to C2

Figure 4

Figure 5.

Figure 6.

Figure 7.

| Europäisches Patentamt European Patent Office Office européen des brevets | EUROPEAN SEARCH REPORT | Application Number EP 12 29 0270 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/279178 A1 (OUTALEB NOUREDDINE [CA] ET AL) 17 November 2011 (2011-11-17) | 1-4,8-10 | INV. H03F1/02 |
| Y | * paragraphs [0003], [0015], [0039] - | 11,12 | H03F1/42 |
| A | [0058]; figures 2,3 * ----- | 5-7 | H03F1/56 H03F3/60 |
| Y | US 8 193 857 B1 (WILSON RICHARD [US]) 5 June 2012 (2012-06-05) | 11,12 | |
| A | * column 2, line 57 - column 4, line 59; figures 1,3 * ----- | 1-10 | |
| X | US 6 128 479 A (FITZPATRICK DOUGLAS D [US] ET AL) 3 October 2000 (2000-10-03) * column 5, line 34 - column 6, line 19; figure 5 * ----- | 1,2 | |
| A | KLOPFENSTEIN R W: "A Transmission Line Taper of Improved Design", PROCEEDINGS OF THE IRE, IEEE, PISCATAWAY, NJ, US, vol. 39, no. 1, 1 January 1956 (1956-01-01), pages 31-35, XP011154230, ISSN: 0096-8390 * the whole document * ----- | 10-12 | TECHNICAL FIELDS SEARCHED (IPC) H03F H01P |

The present search report has been drawn up for all claims

| Place of search | Date of completion of the search | Examiner |
|---|---|---|
| The Hague | 17 December 2012 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 29 0270

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2012

| Patent document cited in search report | | Publication date | Patent family member(s) | | Publication date |
|---|---|---|---|---|---|
| US 2011279178 | A1 | 17-11-2011 | US 2011279178 A1<br>WO 2011145002 A2 | | 17-11-2011<br>24-11-2011 |
| US 8193857 | B1 | 05-06-2012 | CN 102694507 A<br>DE 102012202870 A1<br>US 8193857 B1 | | 26-09-2012<br>06-09-2012<br>05-06-2012 |
| US 6128479 | A | 03-10-2000 | NONE | | |

**EP 2 696 499 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2210028 A, Doherty